**Europäisches Patentamt**

**European Patent Office**

**Office européen des brevets**

(19)

(11) **EP 0 908 426 A1**

(12) **EUROPÄISCHE PATENTANMELDUNG**

(43) Veröffentlichungstag:
14.04.1999 Patentblatt 1999/15

(51) Int. Cl.⁶: **C04B 35/547**, C10M 103/06

(21) Anmeldenummer: 98118994.7

(22) Anmeldetag: 08.10.1998

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **09.10.1997 FR 9712852**

(71) Anmelder:
• **Blösch Holding AG**
  **2540 Grenchen (CH)**
• **Serole, Bernard**
  **26380 Peyrins (FR)**

(72) Erfinder:
• **Serole, Bernard**
  **26380 Peyrins (FR)**
• **Curtins, Hermann**
  **2540 Grenchen (CH)**
• **Paroz, Rémy**
  **2300 La Chaux de Fonds (CH)**

(74) Vertreter:
**EGLI-EUROPEAN PATENT ATTORNEYS**
**Horneggstrasse 4**
**8008 Zürich (CH)**

(54) **Verfahren zur Herstellung von Molybdändisulfid mit hoher elektrischer Leitfähigkeit**

(57) Gegenstand der Erfindung ist ein Verfahren, das, ausgehend von technischen Molybdändisulfidpulvern, die Herstellung von Stücken mit einer elektrischen Leitfähigkeit vergleichbar mit der von Metallen ermöglicht. Bei dem verwendeten Verfahren handelt es sich im wesentlichen um die Herstellung und Behandlung des Pulvers mit anschliessender Kristallisation zur Bildung von ausgerichteten Kristallen. Des Weiteren umfasst der Gegenstand der Erfindung nach dem erfindungsgemässen Verfahren hergestellte Formkörper und deren Verwendung als Target beim PVD-Beschichten von Substraten.

ABBILDUNG 2

## Beschreibung

Die Erfindung liegt auf dem technischen Gebiet der Schmiermittel. Molybdändisulfid kommt insbesondere auf diesem Gebiet entweder als Festschicht oder in Feststoffen oder Ölen und Fetten eingearbeiteter Form zum Einsatz. Molybdändisulfid liegt in Form eines grauschwarzen Feststoffs vor, der Graphit ähnelt, jedoch einen metallischen Glanz besitzt und sich beim Berühren fettig anfühlt.

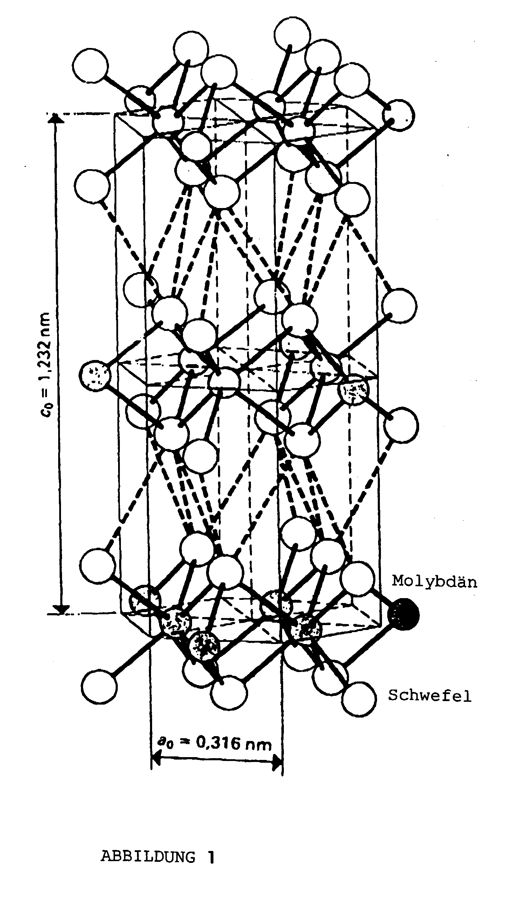

Es besitzt die Formel $MoS_2$ und hat eine hexagonale Kristallstruktur (d6h - c = 1,232 mm - a = 0,316 mm). Die in Abbildung 1 dargestellte Elementarzelle Zeigt Gruppen mit 3 Molybdänatomen und 6 Schwefelatomen. Die Kristalle sind tafelförmig, in der Masse im allgemeinen jedoch blatt-, lamellen- und schuppenförmig. Diese leicht spaltbare Struktur verleiht dem Molybdändisulfid die charakteristischen Eigenschaften eines Schmiermittels, wobei ihr Reibungskoeffizient bei 0,02 bis 0,08 liegt.

Anderseits haftet $MoS_2$ dank der Metall-Schwefel-Bindungen an Metallen. Dadurch ergibt sich eine hervorragende Schmierwirkung über einen sehr breiten Temperaturbereich. Seit etwa dreissig Jahren ist seine Verwendung als Schmiermittel bestens bekannt, und zwar sowohl als Trockenschmiermittel durch Aufsprühen, Beschichten von griffigen Oberflächen, Auftragen in Form von organischen oder silikathaltigen Lacken als auch durch Auftragen in einer dünnen Schicht und auch durch Einarbeiten in Sintermetallen oder als Zusatzstoff für Öle oder Fette.

Bisher konnten Substrate unter Anwendung von PVD-Methoden (Physical Vacuum Deposition) routinemässig nur mittels der Sputter-Technologie mit $MoS_2$ beschichtet werden. Gegenüber dem Sputtern bietet die Verwendung der Arc- bzw. Lichtbogen-Technologie beim Beschichten von Substraten die folgenden und entscheidenden Vorteile:

- Dank Metallionenbeschuss werden die Vakuumkammer und insbesondere die zu beschichtenden Substrate sehr effizient gereinigt, so dass praktisch keine Kontamination durch Ausgasen der Kammerwände, anderer Einrichtungen wie Substrathalter und dergleichen oder gar der Substrate selbst befürchtet werden muss.

- Durch die Modifizierung des „Interface", d.h. der Übergangszone von Substrat zu Beschichtung, gewährleistet die Arc-Technologie eine extrem gute Anbindung der Beschichtung an das Substrat.

- Der Beschichtungsprozess verläuft sehr stabil und kann unter reaktiven oder nichtreaktiven Bedingungen durchgeführt werden.

- Eine hohe Durchsatzrate (Produktivität) und Reproduzierbarkeit der Resultate versprechen eine hohe Wirtschaftlichkeit der Arc- bzw. Lichtbogen-Technologie.

- Die Arc-Technologie erlaubt das Beschichten von Substraten, wie Matrizen für Stanzmaschinen oder Anlagen zum Umformen bzw. Pressen, mit komplizierten dreidimensionalen Geometrien.

Einer solchen Verwendung steht aber die Erfahrung und das daraus resultierende Urteil der Fachwelt entgegen, nach welchem $MoS_2$-Targets in der Arc-Technologie nicht eingesetzt werden können. Deshalb wurde die Aufgabe gestellt, einen Formkörper aus $MoS_2$ bereitzustellen, der eine so hohe elektrische Leitfähigkeit bzw. einen so geringen spezifischen Widerstand aufweist, dass er routinemässig als Target für die physikalische Beschichtung von Substraten, beispielsweise in der Arc-Technologie, eingesetzt werden kann.

Die gestellte Aufgabe wird entsprechend den Merkmalen des unabhängigen Anspruchs 1 gelöst, indem ein Verfahren zur Herstellung eines Formkörpers aus $MoS_2$, mit dessen Hilfe sich mittels einer Behandlung des Molybdändisulfidpulvers unter Vakuum, die zur Reinigung der Kornoberflächen des Pulvers von Oxid und ab- bzw. adsorbiertem Wasser dient, ein geringer spezifischer elektrischer Widerstand, und zwar von weniger als $10^{-3}$ Ohm·cm, erzielen lässt. Bevorzugte Ausführungsformen des erfindungsgemässen Verfahrens ergeben sich aus den abhängigen Ansprüchen 2 bis 11. Bevorzugte, mit diesen Verfahren herstellbare Formkörper bzw. deren Verwendung als Target beim PVD-Beschichten von Substraten ergeben sich aus den Ansprüchen 12 und 13.

Da es sich bei $MoS_2$ um ein diamagnetisches Material handelt, beträgt sein spezifischer elektrischer Widerstand $8,5 \cdot 10^3$ Ohm·cm. Diese niedrige elektrische Leitfähigkeit kann, wie bereits gesagt, zu einer Einschränkung der Auftragsmethoden bei den modernen Dünnschichtabscheidungsverfahren führen. In bestimmten Fällen wäre es ausserdem von Interesse, dass seine Abscheidung auf Metallteilen zu einer leitfähigen Schicht führen würde oder auch dass die in Metallegierungen oder auch Keramiken oder Kunststoffen eingearbeiteten Molybdändisulfidteilchen Leitfähigkeit zeigen würden. Ganz allgemein besitzen Metalle einen spezifischen Widerstand in der Grössenordnung von $10^{-6}$ Ohm·cm, während Isolatoren mehr als $10^{14}$ Ohm·cm aufweisen und Halbleiter mit $10^3$ bis $10^9$ Ohm·cm zwischen beiden liegen.

Der spezifische elektrische Widerstand von $MoS_2$ beträgt bei den herkömmlichen Qualitäten $8,15 \cdot 10^3$ Ohm·cm, wodurch es im Vergleich mit herkömmlichen Metallen folgende Stellung einnimmt:

Ag       = $1,59 \cdot 10^{-6}$ Ohm·cm
Cr       = $13 \cdot 10^{-6}$ Ohm·cm
Bi       = $1,2 \cdot 10^{-4}$ Ohm·cm
$MoS_2$ = $8,5 \cdot 10^3$ Ohm·cm

Da bekannt ist, dass die elektrische Leitfähigkeit eines Festkörpers sich aus der Summe der Teilleitfähigkeiten für jede Ladungsträgerart ergibt, wobei die Teilleitfähigkeit jeweils auf ionische oder elektronische Ladungsträger zurückzuführen ist, ergibt sie sich aus:

$$\sigma = c - z - q - \mu$$

$\sigma =$ Leitfähigkeit
$c =$ Ladungsdichte pro $cm^3$
$\mu =$ Beweglichkeit in $cm^2/v \cdot sec$
$z =$ Ladung in Coulomb

Was die erfindungsgemässen Verfahren betrifft, so sei darauf hingewiesen, dass die Leitfähigkeit durch das Produkt aus der Zahl der ionischen oder elektronischen Ladungen und ihrer Beweglichkeit gegeben ist.

Die elektrischen Eigenschaften von Festkörpern sind bestens bekannt. In Kristallen sind die Atomkerne an den Schnittpunkten eines dreifach periodischen Gitters angeordnet: Abb. 1. Sein Zusammenhalt wird durch Elektronen sichergestellt. Während sich die Elektronen im Atom auf diskrete Energieniveaus verteilen, sind diese Niveaus im Kristall auf breitere erlaubte Energiebänder ausgedehnt, die wegen der Wechselwirkung zwischen Atomen untereinander durch verbotene Bänder voneinander getrennt sind. Ausgehend von den niedrigerliegenden Bändern füllen sich die verschiedenen Bänder je nach der Elektronenzahl des jeweiligen Atoms nach und nach auf. Eine gefüllte Elektronenschale entspricht einem gefüllten Band. Die höherliegenden unvollständigen Schalen ergeben unvollständige Bänder. In Ionenkristallen werden die Bindungen zwischen den Atomen durch Elektronenaustausch sichergestellt; in kovalenten Kristallen werden die gleichen Bindungen durch Zusammenführung von Valenzelektronen bewerkstelligt, um auf diese Weise die äusseren Bahnen abzusättigen. Die entsprechenden Bänder sind vollständig gefüllt und das oberste Band ist leer. Nur bei Metallen ist das Valenzband nicht mit Elektronen abgesättigt. Metalle besitzen eine Ladungsträgerzahl in der Grössenordnung von $10^{23}/cm^3$, Halbleiter von $10^{10}$ bis $10^{15}/cm^3$ und Isolatoren noch weniger.

Der zweite Gesichtspunkt der elektrischen Leitfähigkeit betrifft die Beweglichkeit $\mu$ der negativen Ladungen, der Elektronen, oder der positiven Ladungen, der Löcher. Die Beweglichkeit wird durch mehrere Arten von Hindernissen erniedrigt. Da es sich bei dem Basismaterial $MoS_2$ um ein feines Pulver im Mikron- bzw. Submikronbereich handelt, ergibt sich das erste Hindernis aus den Korngrenzen des Pulvers. An den Kornoberflächen kommt es zu fortschreitender Oxidation, die in der Regel zu 0,3% $MoO_3$ führt, und ausserdem wird Wasser, in der Regel in einer Höhe von 0,5 Gew.-%, ab- bzw. adsorbiert. In einem herkömmlichen Produkt besitzen den Korngrenzen benachbarte Bereiche ein Ladungsdefizit. Das zweite Hindernis beruht auf den Kristallgrenzen. Hexagonale Kristalle, s. Abb. 1, besitzen in jedem Korn - c = 1,232 mm, a = 0,316 mm - aufeinanderfolgende verschiedene Orientierungen, wodurch jedes Korn eine statistisch gesehen gleichachsige Struktur bekommt.

Das erfindungsgemässe Verfahren besteht aus mehreren Stufen, deren Ergebnis darin besteht, dass die elektrische Leitfähigkeit des $MoS_2$ deutlich erhöht wird.

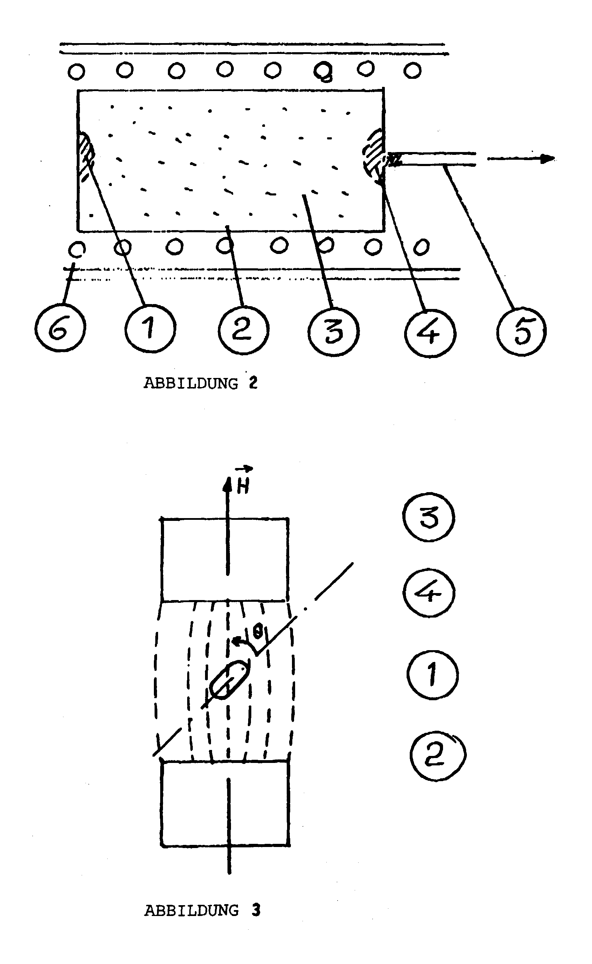

Die erste Stufe besteht darin, die Pulverkörner von den mitgeschleppten Verunreinigungen, insbesondere Wasser und Oxid, zu befreien. Zu diesem Zweck, s. Abb. 2, wird das Molybdändisulfidpulver 3 in einem dichten Reaktor 2 vorgelegt und mittels eines Pumprohrs 5 unter Vakuum gesetzt und durch Einwirken eines Heizelements 6 bei einem sogenannten Sekundärvakuum in der Grössenordnung von $10^{-6}$ mbar auf eine Temperatur von maximal 420°C erhitzt. Für einen beträchtlichen Anteil des Pulvers kann die Zeit zur Erreichung des Vakuums/der Temperatur bis zu 96 Stunden betragen. An beiden Enden des Reaktors 2 wird ein Beutel mit einem stark absorbierenden Mittel angebracht. Hierbei verfährt man zweckmässigerweise so, dass man die Oxide mittels eines Halogenids gemäss der Patentschrift FR 94 10 875 gleichzeitig angreift. Bei dieser Stufe handelt es sich um eine Vorstufe, da die Erfahrung gezeigt hat, dass die Wirkung der nachfolgenden Stufen des erfindungsgemässen Verfahrens durch Oberflächenverunreinigungen und jenen in den an die Körner angrenzenden Bereichen nachteilig beeinflusst wird. Diese in sich wenig wirkungsvolle Stufe muss einen integralen Bestandteil des Verfahrens darstellen.

In diesem Fall wurde eine rechnerische Simulierung durchgeführt, bei der die Pulverkörner sieben Serien von Kugeln angeglichen wurden, deren Durchmesser eine arithmetische Reihe darstellen und die einen Korngrössenbereich von 25 $\mu$m bis 350 $\mu$m aodecken. Die Berechnung hat ergeben, dass bei Abscheidung einer leitenden Schicht, die etwa 27% der Kornoberfläche abdeckt, eine beträchtliche Leitfähigkeit erzielt werden könnte. Besitzen die Molybdändisulfidkörner einen Querschnittsfaktor von mehr als 1, d.h. sind die Kugeln abgeflacht oder besitzen die Körner beispielsweise eine kubische Gestalt, so lässt sich dieser Anteil noch weiter senken. Durch Messungen der elektrischen Leitfähigkeit in Verbindung mit rasterelektronenmikroskopischen Untersuchungen wurde dieses Ergebnis bestätigt.

Bei weiteren Untersuchungen in dieser Richtung hat sich gezeigt, dass bei Abscheidung einer vollkommen diskontinuierlichen leitenden Schicht in Form von Körnern mit einem Durchmesser von mehreren Hundert Nanometern eine Leitfähigkeit der Molybdändisulfidteile erzielt werden konnte, die für die erfindungsgemässe Anwendung ausreichend war. Dieses durch Messungen der elektrischen Leitfähigkeit in Verbindung mit rasterelektronenmikroskopischen Untersuchungen bestätigte Ergebnis wurde dem Tunneleffekt zugeschrieben.

Tatsächlich stellt sich zwischen zwei durch einen geringen Abstand d voneinander getrennten leitenden Flächen eine Potentialschwelle ein, die (vgl. Formel 1) dem Durchgang eines Elektronenstroms von der einen Fläche 1 zur anderen Fläche 2 entgegenwirkt. Diese Schwelle besitzt folgenden Wert:

$$\Delta \phi = \tfrac{1}{2} (\phi 1 + \phi 2) \qquad (1)$$

wobei $\phi$ die Austrittsarbeit in eV bedeutet.

Legt man an die zwei Oberflächen des an sich nichtleitenden Molybdändisulfids, auf welche leitende Körner aufgebracht sind, ein elektrisches Feld an, so können - auch wenn sich diese Körner nicht berühren bzw. die leitenden Metallüberzüge auf den Körnern nicht vollständig sind - die Elektronen mit Hilfe des Tunneleffekts von dem einen zum anderen springen, wobei die Stromdichte durch:

$$i = e \exp(-A \cdot \Delta\phi^{1/2} \cdot d) \qquad (2)$$

gegeben ist; wobei d den Kornabstand in nm bedeutet und A = 10,25 beträgt, wenn d in nm und $\Delta\phi$ in eV und i in Ampère angegeben ist.

Die zweite Stufe des erfindungsgemässen Verfahrens besteht darin, das Pulver in einem unter Vakuum stehenden Reaktor bei erhöhter Temperatur und erhöhtem Druck über einen längeren Zeitraum heiss zu verpressen, um auf diese Weise zunächst eine Dichte von mindestens 96% der theoretischen Dichte, also etwa 4,76 g/cm$^3$, und dann eine Umkristallisation mit anschliessender Koaleszenz der Anfangskristalle zu erzielen. Bei Abwesenheit von Korngrenzenbarrieren entstehen hierbei Grosskristalle. In der Regel lässt sich dieses Ergebnis durch 8-stündige Einwirkung eines Drucks von 500 bar und einer Temperatur von maximal 600°C erzielen. Zu diesem Zeitpunkt ist es möglich, eine Leitfähigkeit in der Grössenordnung von $1\times10^{-4}$ Ohm $\cdot$ cm zu erzielen, die mit der eines Metalls wie z.B. Wismut vergleichbar ist, und das bei den hierfür üblichen Temperaturen von 300 bis 600 K. Bei tiefen Temperaturen (beispielsweise 150 K) nimmt die Leitfähigkeit zwar noch zu, doch ist dies für die von dem erfindungsgemässen Verfahren vorgesehenen Anwendungen von geringem Nutzen. Diese Stufe erfolgt entweder auf einer isothermen Axialpresse oder durch isostatisches Heissverpressen.

Eine Variante der zweiten Stufe des zuvor beschriebenen Verfahrens besteht in der Ausnutzung des diamagnetischen Charakters des Molyodändisulfids MoS$_2$. Es sei daran erinnert, dass Körper, die im Gegensatz zu magnetischen Stoffen eine magnetische Permeabilität $\mu$ unterhalb der im Vakuum besitzen, als nichtmagnetisch bezeichnet werden. Die Kraftlinien eines Magnetfelds werden in diesem Fall nach aussen gedrängt. Die Punkte, durch welche die Kraftlinien gehen, werden magnetisch positiv aufgeladen, während jene, durch die sie ausströmen, magnetisch negativ aufgeladen werden. Hierdurch ergibt sich ein durch das Magnetfeld induziertes, aber gegen es gerichtetes magnetisches Moment $\vec{M}$, wie dies in Abbildung 3 gezeigt ist. Ein Kristall 1 aus diamagnetischem Material wird zwischen zwei Pole 2 und 3 eines Magneten gebracht und erfährt bei einem Winkel $\theta$ des Kristalls 1 mit den Kraftlinien 4 von 45° eine maximale und bei Orientierung des Kristalls entlang den Kraftlinien, also bei einem Winkel von Null, überhaupt keine Kopplung. Dies hat einen sekundären, von Null verschiedenen Effekt zur Folge, der dazu neigt, die Kristalle in der gleichen Richtung zu orientieren. In der Praxis wird der Reaktor, dessen Vorbereitung in Ább. 2 dargestellt ist, unter Vakuum nach einem dem Fachmann bestens bekannten Schweissverfahren zugeschmolzen. Anschliessend wird er zwischen zwei starke Permanentmagnete gebracht, die mit ihren zwei Flachseiten, s. Abb. 3, miteinander verbunden sind. Der Reaktor 2 mit dem zugeschmolzenen Pumprohr 1 wird zwischen die Magnete 3 und 4 gebracht. Bei den Magneten handelt es sich um zwei starke, beispielsweise 300 kg schwere Flachmagnete, deren Polschuhe gleich- und nicht gegengerichtet sind. Während der Umkristallisation sind die Kristalle sehr instabil, doch diese geringe Kopplung reicht aus, ihnen eine statistische Vorzugsorientierung zu verleihen, wodurch ihre Leitfähigkeit je nach den Parametern um das 2- bis 10-fache erhöht werden kann.

Die dritte Stufe des erfindungsgemässen Verfahrens geht von der Tatsache aus, dass Molybdändisulfid MoS$_2$ ein Halbleiter vom Typ P ist. Die Leitfähigkeit von Halbleitern kann nun durch Zugabe geringer Mengen an Verunreinigungen erhöht werden. Bildet eine dreiwertige Verunreinigung wie z.B. Bor, Indium, Aluminium oder Gallium im Valenzband ein Elektronenakzeptorniveau unter Bildung von Löchern in diesem Band, so gelangt man zu einem Halbleiter P. Als dreiwertiges Atom ist Bor von Interesse. Wird ein Mo-Atom des MoS$_2$-Kristallgitters durch Bor ersetzt, so bildet das drei Valenzelektronen aufweisende Bor Bindungen zu 3 Nachbaratomen, wobei die vierte Bindung jedoch frei bleibt. Zur Absättigung dieser freien Bindung wird leicht ein benachbartes Valenzelektron eingefangen, wodurch im Valenzband ein Loch entsteht. Dieses Loch verschiebt sich leicht schrittweise durch den Kristall. Bei diesem Atom handelt es sich um einen Akzeptor. Bei den Arbeitstemperaturen sind alle Akzeptoratome ionisiert und die Konzentration an Löchern des Valenzbandes wird um die Konzentration an Akzeptoren erhöht. Ein mit der Gleichstrom-Kathodenzerstäubung mittels Magnetron (PVD: Sputter) kompatibler spezifischer elektrischer Widerstand, also von mindestens $10^{-2}$ bis $10^{-3}$ Ohm $\cdot$ cm, kann z.B. mit 45 ppb Bor, entsprechend $10^{13}$ Atomen/cm$^3$, erzielt werden.

Bei dem erfindungsgemässen Verfahren hat sich gezeigt, dass Zusätze vom Mischungs- oder Legierungstyp, entweder im Verlauf der $MoS_2$-Herstellung oder im Verlauf der Formgebung, relativ wirkungslos sind. Das Ionenimplantationsverfahren funktioniert hingegen erstaunlich gut. Diese Implantation kann je nach Grösse der $MoS_2$-Körner an der Gesamtheit der Kornmasse erfolgen. Bei grossen Körnern kann die Implantation lediglich an der Kornoberfläche erfolgen oder, falls unbedingt erforderlich, kann sie sich auf eine Schicht an der Kornoberfläche beschränken. In diesem Fall wird die elektrische Leitfähigkeit sehr genau durch die Kornoberfläche bestimmt.

Die vierte und letzte Stufe des erfindungsgemässen Verfahrens betrifft die Verwendung des erhaltenen leitenden Materials. Falls das Material zum Vermischen mit einem Lack, Öl, Pulver usw. pulverförmig sein muss, greift man auf das dem Fachmann bestens bekannte Granulierverfahren zurück. Je nach der geforderten elektrischen Leitfähigkeit durchläuft das technische $MoS_2$-Pulver ganz oder teilweise die Stufen 1, 2 und 3 mit oder ohne Variante, jedoch mindestens die Stufen 1 und 2. Anschliessend wird der erhaltene Block vermahlen und auf die gewünschte Teilchengrösse gesiebt. Soll das Material hingegen in Blockform entweder direkt oder zur Herstellung von Abscheidungen in dünner Schicht, zur kathodischen Zerstäubung, Verdampfung, im Lichtbogen oder zum Aufsprühen verwendet werden, so wird der durch Pressen hergestellte Block meistens zu Platten zurechtgesägt und dann maschinell zu den geforderten Formen und Grössen verarbeitet.

Das erfindungsgemässe Verfahren lässt sich ohne nennenswerte Änderungen zum Einarbeiten von Molybdändisulfid in Verbundwerkteile einsetzen. Das verfahrensgemäss behandelte Pulver wird in diesem Fall mit Metall-, Legierungs-, Keramik- oder Kunststoffpulvern vermischt und dann verpresst. Analog kann dieses Pulver auch als Matrix für einen Faser-Verbundwerkstoff dienen, der anschliessend die verschiedenen Stufen des Verfahrens durchläuft.

Als Beispiel für die technische Anwendung des erfindungsgemässen Verfahrens sei die Herstellung von 1200 x 220 x 20 mm grossen Molyodändisulfidplatten bzw. Formkörpern hoher Dichte genannt, die frei von Rissen sind und eine elektrische Leitfähigkeit aufweisen, die der eines Metalls vergleichbar ist. Ein handelsübliches Pulver mit einer typischen Reinheit von 99% und einem beträchtlichen Anteil an Wasser und Oxid sowie einer Teilchengrösse in der Grössenordnung von 1 μm wird in Chargen von 120 kg in einem Edelstahlreaktor vorgelegt, der allmählich und in aufeinander abgestimmter Weise auf ein Vakuum von 10 mbar und eine Temperatur von maximal 420°C gebracht wird. Nach Erreichen und Stabilisierung dieser Bedingungen werden diese 24 Stunden aufrechterhalten. An beiden Enden des Reaktors werden Beutel mit Titan-Zirkonium-Pulver oder -Feinspänen befestigt, und der Reaktor wird erhitzt und an eine Vakuumpumpe angeschlossen, wie dies in Abb. 2 gezeigt ist. Die Praxis hat gezeigt, dass das Produkt in Stückform erhalten wird. Es wird gemahlen, gesiebt und homogenisiert. Anschliessend wird es einer Ionenimplantation in einer Konzentration von $10^{13}$ Atomen/$cm^3$ unterzogen, was einer Verteilung dieser Atome im Kristallgitter von $MoS_2$ von mehreren 10 ppb entspricht. Das erhaltene Pulver wird anschliessend in einen wie zuvor zwei Beutel enthaltenden 1500 x 300 x 300 mm grossen und 3 mm starken geschweissten Edelstahlreaktor gegeben und zu einer kompakten Masse mit einer relativen Dichte von 66% geformt. Anschliessend setzt man den Reaktor mittels eines Pumprohrs unter Vakuum, wie zuvor erläutert, und unterzieht ihn der gleichen Behandlung in Bezug auf Vakuum und Temperatur. Im Anschluss daran wird das Pumprohr mit einer Presse flachgewalzt und unter Argon abgeschmolzen. Dies wird als TIG-Verfahren bezeichnet. Der zugeschmolzene Reaktor wird anschliessend zwischen zwei Permamentmagnete gebracht, die jeweils 300 kg schwer sind und deren Pole gleichgerichtet sind. Das Ganze wird in einen Ofen zum isostatischen Heissverpressen gebracht. Der Ofen wird auf 600°C erhitzt. Ab 300°C wird der Druck auf 500 bar erhöht. Hierzu werden bis zu 2 Stunden benötigt, wonach der Ofen noch 8 Stunden bei diesen Bedingungen gehalten wird. Die langsame, kontrollierte Abkühlung erfolgt über einen Zeitraum von 6 Stunden. Der Edelstahlreaktor wird anschliessend aufgeschnitten und der Block daraus entfernt. Anschliessend wird der Block zu Platten oder Rundstücken zurechtgesägt und dann maschinell zu der gewünschten Grösse des Formkörpers verarbeitet.

Die Vorteile der Verwendung eines Formkörpers aus $MoS_2$ als Target in der Arc-Technologie gegenüber den im Stand der Technik bekannten Methoden sind:

- Die Beschichtungen können optimal an das Substrat (beispielsweise ein Werkzeug, sei dies nun verformend oder spanabhebend einzusetzen bzw. eine Gleitfläche), an die Härte der Schicht (Hartstoffschichten aus Ti-Verbindungen bzw. weiche Feststoffschmierschichten aus $MoS_2$, $WS_2$ oder anderen Metallchalkogeniden) und an den zu bearbeitendem Werkstoff bzw. an den Reibungspartner angepasst werden.

- Mittels der Lichtbogentechnologie wird praktisch alles verdampfte $MoS_2$-Material ionisiert und erhält dadurch eine hohe chemische Reaktivität. Deswegen entsteht eine bevorzugte, besonders dichte und kompakte Übergangszone auf dem Substrat. Zur Ausbildung einer solchen, bevorzugten Übergangszone trägt auch der hohe Ionisationsgrad und damit die hohe Energie bei, mit welcher die Teilchen des Beschichtungsmaterials auf dem Substrat auftreffen.

**Patentansprüche**

1. Verfahren zur Herstellung eines Formkörpers aus MoS$_2$, mit dessen Hilfe sich mittels einer Behandlung des Molybdändisulfidpulvers unter Vakuum, die zur Reinigung der Kornoberflächen des Pulvers von Oxid und ab- bzw. adsorbiertem Wasser dient, ein geringer spezifischer elektrischer Widerstand, und zwar von weniger als 10$^{-3}$ Ohm·cm, erzielen lässt.

2. Verfahren nach Anspruch 1, wobei das so hergestellte Pulver einer Granulierung unterzogen wird.

3. Verfahren nach Ansprüchen 1 und 2, wobei das Pulver einer Ionenimplantation mit einem vorzugsweise dreiwertigen Atom unterzogen wird, wobei diese Implantation im Innern oder lediglich an der Oberfläche stattfindet.

4. Verfahren nach Anspruch 1 und einem der Ansprüche 2 und 3, wobei auf dem Molybdändisulfidpulver lediglich an der Oberfläche eine diskontinuierliche leitende Schicht abgeschieden wird.

5. Verfahren nach Anspruch 1 und einem der Ansprüche 2 und 3, wobei auf den Körnern des Molybdändisulfidpulvers leitende Körner abgeschieden wurden, die derart voneinander getrennt sind, dass die elektrische Leitfähigkeit durch den Tunneleffekt gewährleistet wird.

6. Verfahren nach Anspruch 1 und einem oder mehreren der vorhergehenden Ansprüche, wobei das Pulver während eies zur Umkristallisation des MoS$_2$ ausreichend langen Zeitraums bei erhöhter Temperatur heissverpresst wird.

7. Verfahren nach Ansprüchen 1 und 6 und einem oder mehreren der vorhergehenden Ansprüche, wobei das Verpressen in einem Magnetfeld derart erfolgt, dass die Kristalle des diamagnetischen Materials ausgerichtet werden.

8. Verfahren nach Ansprüchen 1 und 6 und einem der vorhergehenden Ansprüche, wobei das in Pulverform eingesetzte Material nachgemahlen wird.

9. Verfahren nach Ansprüchen 1 und 6 und einem der vorhergehenden Ansprüche, wobei das Material in fester Form eingesetzt und ausgehend von einem gepressten Block maschinell verarbeitet wird.

10. Verfahren nach Ansprüchen 1 und 6 und einem der vorhergehenden Ansprüche, wobei das Material zusammen mit einem anderen pulverförmigen Material in Stückform erhalten wird.

11. Verfahren nach Ansprüchen 1 und 6 und einem der vorhergehenden Ansprüche, wobei das Material zusammen mit Fasern in Stückform erhalten wird.

12. Formkörper, hergestellt nach dem Verfahren gemäss einem oder mehreren der Ansprüche 1 bis 11.

13. Verwendung eines Formkörpers gemäss Anspruch 12, wobei der Formkörper als Target beim PVD-Beschichten von Substraten verwendet wird.

ABBILDUNG 1

ABBILDUNG 2

ABBILDUNG 3

N    S                    N    S

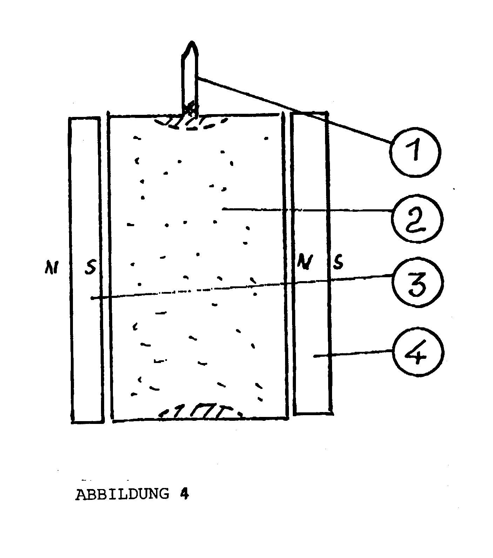

ABBILDUNG **4**

**Europäisches Patentamt**

## EUROPÄISCHER RECHERCHENBERICHT

Nummer der Anmeldung

EP 98 11 8994

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | EP 0 108 892 A (NUKEM GMBH) 23. Mai 1984 <br> * Ansprüche 1-5 * <br> --- | 1-13 | C04B35/547 <br> C10M103/06 |
| A | US 3 465 278 A (E.L. KERN ET AL.) 2. September 1969 <br> * Spalte 2, Zeile 36 – Zeile 48; Ansprüche 1-5 * <br> ----- | 1-13 | |

RECHERCHIERTE SACHGEBIETE (Int.Cl.6)

C04B
C10M

Der vorliegende Recherchenbericht wurde für alle Patentansprüche erstellt

| Recherchenort | Abschlußdatum der Recherche | Prüfer |
|---|---|---|
| DEN HAAG | 22. Dezember 1998 | Hauck, H |

**ANHANG ZUM EUROPÄISCHEN RECHERCHENBERICHT
ÜBER DIE EUROPÄISCHE PATENTANMELDUNG NR.**                EP 98 11 8994

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-12-1998

| Im Recherchenbericht angeführtes Patentdokument | Datum der Veröffentlichung | Mitglied(er) der Patentfamilie | Datum der Veröffentlichung |
|---|---|---|---|
| EP 108892 A | 23-05-1984 | DE 3237163 A | 12-04-1984 |
| US 3465278 A | 02-09-1969 | KEINE | |

EPO FORM P0461

Für nähere Einzelheiten zu diesem Anhang : siehe Amtsblatt des Europäischen Patentamts, Nr.12/82